Europäisches Patentamt

European Patent Office

Office européen des brevets

(19)

(11) Numéro de publication: **0 196 256**
**B1**

(12) **FASCICULE DE BREVET EUROPEEN**

(45) Date de publication du fascicule du brevet: **22.11.90**

(51) Int. Cl.⁵: **H 01 R 4/18**

(21) Numéro de dépôt: **86400561.6**

(22) Date de dépôt: **17.03.86**

(54) Borne de contact électrique thermo-enfichable sur une carte de circuit imprimé et connecteur comportant de telles bornes.

(30) Priorité: **19.03.85 FR 8504042**
**28.10.85 FR 8515973**

(43) Date de publication de la demande:
**01.10.86 Bulletin 86/40**

(45) Mention de la délivrance du brevet:
**22.11.90 Bulletin 90/47**

(84) Etats contractants désignés:
**AT BE CH DE FR GB IT LI LU NL SE**

(56) Documents cités:
**EP-A-0 081 372**
**EP-A-0 123 376**
**FR-A-2 279 857**

(73) Titulaire: **SOURIAU ET CIE**
**9-13, rue du Général Galliéni**
**F-92103 Boulogne-Billancourt (FR)**

(72) Inventeur: **Dubertret, Alain**
**30, rue Edouard La Férière**
**F-92310 Sevres (FR)**
Inventeur: **Rizzo, Gilles**
**4, rue Albert Thomas**
**F-91560 Crosnes (FR)**
Inventeur: **Bargain, Raymond**
**5 Bis, rue Henri Dunand**
**F-78500 Sartrouville (FR)**
Inventeur: **Mendez, Michel de**
**7, Voie de l'Etoile du Mesnil**
**F-91310 Monthlery (FR)**
Inventeur: **Thenaisie, Jacky**
**247, avenue Rubillard**
**F-72000 Le Mans (FR)**

(74) Mandataire: **Martin, Jean-Jacques et al**
**Cabinet REGIMBEAU 26, Avenue Kléber**
**F-75116 Paris (FR)**

Courier Press, Leamington Spa, England.

**Description**

La présente invention est relative à une borne de contact électrique thermo-enfichable sur une carte de circuit imprimé et au connecteur comportant de telles bornes.

Les connecteurs électriques enfichables à force sur une carte de circuit imprimé actuellement connus sont constitués par un corps de connecteur comportant une pluralité de bornes de contact mâle ou femelle solidaires du corps du connecteur. Chaque borne de contact est prolongée à la base du corps de connecteur par une partie enfichable. L'ensemble des parties correspondantes des bornes de contact est destiné à être enfiché à force dans les orifices métallisés correspondants de circuits imprimés afin d'assurer le contact électrique correspondant et la rétention mécanique de l'ensemble du connecteur par interaction borne-trou.

Dans ce type de connecteur, la connexion électrique et le blocage mécanique sont donc assurés par la déformation de la borne de contact et/ou de la carte de circuit imprimé au niveau de l'orifice correspondant sans nécessiter d'apport de brasure.

Pour cette raison, l'ensemble des bornes de contact du connecteur et la carte de circuit imprimé est soumis à des contraintes et à des frottements très importants, lors des insertions et extractions successives de ce type de connecteur, lesquels entraînent des détériorations rapides des métallisations des orifices et des parties correspondantes des bornes de contact.

De plus, dans le cas de connecteurs comportant un grand nombre de bornes de contact, l'insertion ou l'extraction de ces connecteurs nécessite l'application d'efforts globaux très importants, lesquels ne peuvent être appliqués au moyen des procédés classiques d'insertion.

Par ailleurs du document EP—A—0 123 376 il est connu un connecteur électrique pour carte imprimé comportant plusieurs feuilles minces, en matériau mémoire de forme présentant un état mémoire de forme stable mémorisé, disposées autour de trous percés dans le circuit imprimé et adaptées pour recevoir des picots de façon à établir une connexion mécanique et électrique. Les picots sont introduits à une température telle que les feuilles se laissent facilement déformer. A partir d'une première température prédéterminée les feuilles tentent de revenir à leur position d'origine et de ce fait enserrent fermement les picots établissant par la même une bonne connexion mécanique et électrique. A partir d'une deuxième température prédéterminée les feuilles restent selon leur position déformée et de ce fait permettent l'engagement/dégagement sans effort desdits picots.

La présente invention a pour objet de remédier aux inconvénients précités par la mise en oeuvre d'un connecteur thermo-enfichable sur une carte de circuit imprimé pour lequel l'effort global nécessaire pour la mise en place à l'insertion et/ou à l'extraction du connecteur est pratiquement supprimé.

Un autre objet de la présente invention est la mise en oeuvre d'un connecteur précité pour lequel, du fait de la quasi suppression de l'effort global de mise en place, les phénomènes d'usure et de détérioration des connecteurs de l'art antérieur et de leurs circuits imprimés associés sont supprimés.

Un autre objet de la présente invention est la mise en oeuvre d'un connecteur précité présentant, après mise en place, une rétention mécanique identique ou même supérieure à celle des connecteurs enfichables à force de l'art antérieur.

Le connecteur électrique thermo-enfichable sur une carte de circuit imprimé selon l'invention comprend une pluralité de bornes de contact mâles ou femelles enfichables rendues solidaires par au moins un support isolant. Il est remarquable en ce que les bornes de contact comportent au moins une partie enfichable constituée en un matériau à mémoire de forme. La partie enfichable de chacune des bornes est conformée aux dimensions de sa forme finale d'utilisation après enfichage, correspondant à son état de mémoire de forme stable, de manière à assurer la rétention mécanique et le contact électrique avec l'orifice correspondant. La même partie enfichable est susceptible d'occuper un deuxième état de forme, mémorisé ou non, de façon à pouvoir être introduite et/ou retirée de son orifice correspondant.

L'invention trouve application dans le domaine correspondant des connecteurs enfichables à force sur une carte de circuit imprimé pour tout type de circuit imprimé et dans tout domaine d'utilisation de ceux-ci.

D'autres détails et avantages de l'invention seront mieux compris à la lecture de la description et à l'observation des dessins ci-après dans lesquels:

la figure 1 représente en 1a et 1b respectivement une vue en coupe selon la dimension transversale d'un connecteur de l'invention et d'une borne de contact constituant ce connecteur,

les figures 2a et 2b représentent des modes de réalisation avantageux d'une borne de contact telle que représentée en figure 1a,

la figure 3 représente une variante de réalisation non limitative d'une borne de contact susceptible d'équiper le connecteur de l'invention,

la figure 4 représente une vue de face d'une borne de contact conforme à l'invention, la borne étant placée dans son orifice correspondant lequel est représenté en vue arrachée afin de bien montrer la structure de la borne de contact,

les figures 5a, 5b, 5c représentent un mode opératoire particulièrement avantageux permettant la mise en oeuvre de la borne de contact telle que représentée en figure 4,

la figure 5d représente un schéma illustratif du processus dit d'éducation auquel peut être soumise la borne telle que représentée en figure 5c afin d'obtenir, pour celle-ci, deux états de mémoire de forme réversibles pour lesquels le passage réversible de l'un à l'autre état peut être obtenu par seule modification de la température de la partie enfichable ou de la borne de contact,

la figure 6 représente un mode de réalisation particulier de la borne de contact de l'invention.

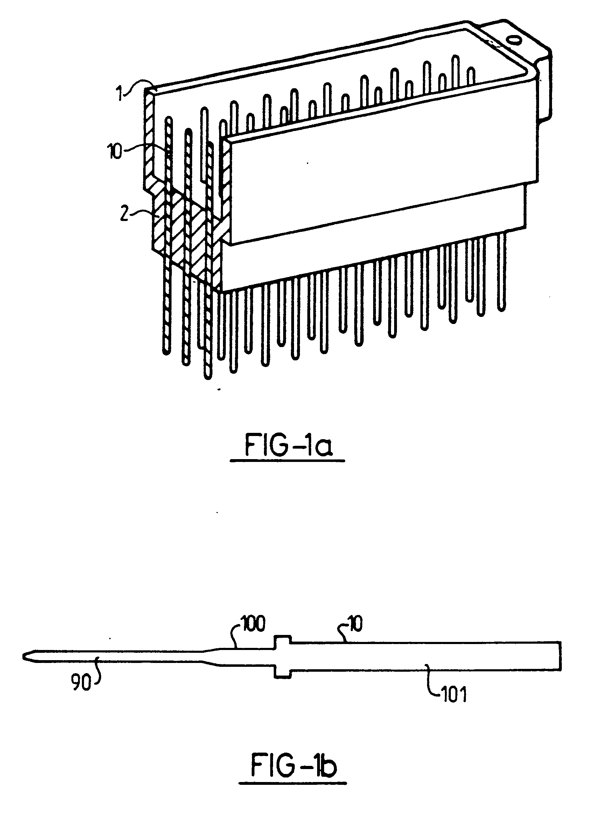

Le connecteur électrique thermo-enfichable sur une carte de circuit imprimé, objet de l'invention, comprend une pluralité de bornes de contact 10 mâles ou femelles, enfichables, rendues solidaires par au moins un support isolant 2. Sur la figure 1a, représentant une coupe selon la dimension transversale du connecteur, les bornes de contact 10 sont noyées dans le support isolant 2 qui, de manière non limitative, est supposé en fait constituer la coquille ou corps du connecteur 1. Les bornes de contact 10, ainsi que représentées notamment en figure 1b, comportent au moins une partie enfichable 100 constituée en un matériau à mémoire de forme conducteur. La partie enfichable 100 de chacune des bornes est conformée tout d'abord aux dimensions de sa forme finale d'utilisation après enfichage, correspondant à un état de mémoire de forme stable, à la température d'utilisation du connecteur. Les parties enfichables 100 des bornes de contact mâles ou femelles 10 étant engagées dans la métallisation des trous correspondant de la carte de circuit imprimé, l'état de mémoire de forme stable précité permet d'assurer la rétention mécanique et le contact électrique avec l'orifice précité. Les parties enfichables 100 sont en outre conformées de façon à occuper, soit de manière non mémorisée, soit de manière mémorisée, un deuxième état de forme à température inférieure à la température de transition Ms du matériau. La température Ms est la température à laquelle la phase martensitique du matériau à mémoire de forme, commence à se former d'elle-même. De cette façon, et dans ce deuxième état de forme, non mémorisé ou mémorisé, le connecteur et les bornes de contact peuvent être introduites et/ou retirées des orifices correspondants, pratiquement sans effort notable.

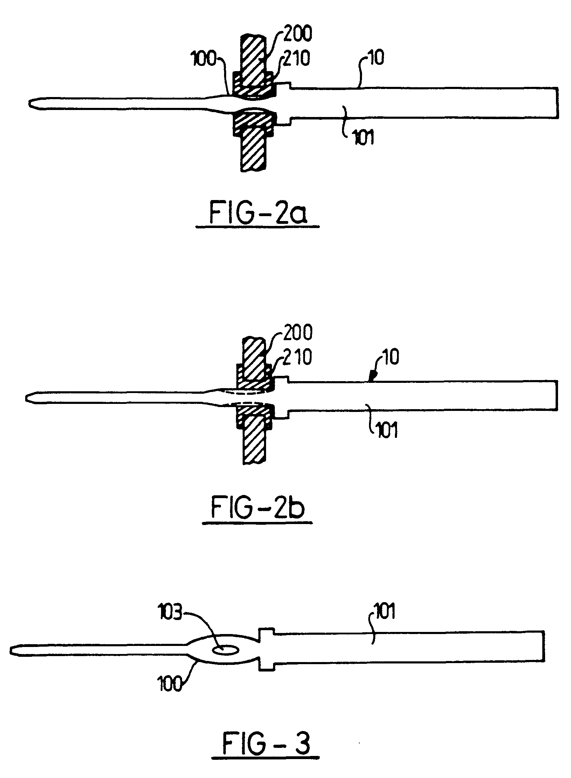

Le caractère non mémorisé ou mémorisé du deuxième état de forme de la partie enfichable 100 de chaque borne de contact 10, sera expliqué de manière plus approfondie en liaison avec les figures 2a et 2b respectivement. Il faut tout d'abord indiquer que le premier état de mémoire de forme est stable à la température ambiante. Il faut également indiquer, que ce premier état de mémoire de forme est stable à basse température, c'est-à-dire jusqu'à la température la plus basse prévue au cahier des charges définissant le domaine d'utilisation de ce type de connecteur. A titre d'exemple non limitatif, le premier état de mémoire de forme est choisi stable jusqu'à des températures de −65°C.

Le deuxième état de forme lorsque celui-ci est non mémorisé, est un état de forme occupé par la partie enfichable 100, lorsque celle-ci est amenée à une température inférieure à la température de transition Ms du matériau constituant ladite partie enfichable, sous l'influence des contraintes exercées par l'orifice correspondant sur la partie enfichable considérée, ou plus précisément par la métallisation 210 de l'orifice correspondant, ménagé dans la plaquette de circuit imprimé 200 ainsi que représenté en figure 2a. Comme on pourra l'observer sur cette même figure 2a, l'état de forme occupé par la partie enfichable 100 sous l'influence des contraintes exercées par la métallisation 210, apparaît pour l'essentiel localisé au niveau de cette métallisation, c'est-à-dire de la zone de contact entre cette métallisation et la partie enfichable 100. Lors du retrait du connecteur et en définitive de chacune des bornes de contact 10 précitées, le deuxième état de forme se produit en outre successivement sur les autres parties de la partie enfichable 100, mises en contact au cours soit de l'enfichage, soit de la déconnexion du connecteur.

Le deuxième état de forme, lorsqu'au contraire celui-ci est mémorisé, se produit sur la totalité de chaque partie enfichable 100 des bornes de contact 10, par seul abaissement de la température correspondante des parties enfichables, en deçà de la température de transition Ms en l'absence ou en présence de contraintes exercées par la métallisation 210 des orifices, ainsi qu'il apparaît en figure 2b. Bien entendu, les transitions du premier état de mémoire de forme au deuxième état de mémoire de forme sont réversibles et peuvent être provoquées sur un nombre important de cycles correspondant à l'utilisation du connecteur.

Une description détaillée d'un mode de réalisation particulier de bornes de contact spécialement adaptées à la mise en oeuvre d'un connecteur selon l'invention sera maintenant donnée au moyen des figures 1b et 3. Chaque borne de contact 10 comporte une zone de raccordement 90 susceptible de recevoir un câble électrique à connecter. Une partie enfichable 100 allongée, est mécaniquement solidaire de la zone de raccordement et de la partie active de contact 101 mâle ou femelle. La partie enfichable 100 comporte au moins une dimension transversale à son axe longitudinal, sensiblement variable. Par exemple, ainsi que représenté en figure 1b, la partie enfichable 100 est sensiblement en forme de lame ou, ainsi que représenté en figure 3, en forme d'ovale et peut comporter un ou plusieurs évidements 103.

Bien entendu, la totalité de la borne 10 peut en outre être constituée en un matériau à mémoire de forme.

Parmi les matériaux à mémoire de forme susceptibles de permettre la mise en oeuvre du connecteur de l'invention, les compositions métalliques choisies dans le groupe des composés nickel-titane, nickel-aluminium, nickel-titane-fer, cuivre-zinc-aluminium, cuivre-aluminium-nickel peuvent être utilisées sous forme de composés intermétalliques ou sous forme alliée.

A titre d'exemple non limitatif, des bornes de connexion ont pu être réalisées, comportant 4% d'aluminium, 28% de zinc et le reste du pourcentage en cuivre, de manière à présenter une température de transition voisine de −80°C. Bien entendu, d'autres alliages tels que par exemple les alliages du type cuivre-aluminium-nickel peuvent être utilisés en raison de leur meilleure tenue aux phénomènes de corrosion et de vieillissement.

Un mode de réalisation particulièrement avantageux de bornes de contact 10 mâles ou femelles, sera maintenant donné dans le cas ou la partie enfichable 100 comporte deux états de mémoire de forme mémorisés. Le matériau à mémoire de forme étant disponible sous forme de feuilles ou de bandes, les bornes de contact 10 sont tout d'abord obtenues par usinage conventionnel ou par découpage, lesdites bornes et en particulier la partie enfichable 100 de celles-ci est conformée aux formes et dimensions finales constituant le premier état de mémoire de forme, tel que représenté par exemple sur les figures 1b et 3. La borne de contact 10 est alors soumise à un traitement thermique capable d'amener celle-ci en état de phase cristallographique de type austénitique. La borne de contact 10 est ensuite soumise à un refroidissement à une température voisine de la température ambiante, par exemple de manière non limitative au moyen d'un traitement du type trempage de de façon à éviter l'apparition de phase cristallographique parasite.

La borne de contact 10 est ensuite soumise au niveau de sa partie enfichable 100 à un processus dit d'éducation.

Le processus d'éducation consiste à imposer répétitivement à la partie enfichable 100, une contrainte mécanique telle que cette dernière soit, dans cette zone, déformée de manière à amener ladite partie enfichable 100 dans une position de forme voisine du deuxième état de mémoire de forme et à soumettre l'ensemble, la contrainte étant maintenue, à un abaissement de température susceptible d'amener la partie enfichable 100 en état de phase martensitique. L'abaissement de température peut être réalisé au moyen de toute source de froid appliquée soit à l'ensemble de la borne de contact 10, soit au niveau de la seule partie enfichable 100. La contrainte mécanique peut être appliquée par tout moyen, tel qu'une presse ou analogue jusqu'à obtenir la position de mémoire de forme souhaitée. Après suppression de la contrainte mécanique, la borne de contact 10 est soumise à un réchauffement progressif à température ambiante. La borne de contact 10 reprend alors son état de forme stable ou premier état de mémoire de forme. La répétition du cycle imposé pour l'éducation telle que définie précédemment, doit être suffisante pour obtenir un bon degré de reproductibilité des transitions entre le premier état et le deuxième état de mémoire de forme ultérieur par seul abaissement de la température de la borne de contact 10 mâle ou femelle, à une température inférieure à la température de transition Ms, puis par une élévation successive de la température de la borne de contact 10 à une température supérieure à la température Af pour le retour à la position ou étape à mémoire de forme initiale dans l'état austénitique. La commande en température du connecteur de l'invention peut être obtenue à partir de toute source froide normalement disponible en milieu industriel et en particulier au moyen de l'azote liquide.

Bien entendu, le processus d'éducation précité et de fonctionnement des bornes de contact 10 enfichées dans les trous métallisés, pourra être divers et varié. Ainsi, il est possible de réaliser des connexions s'établissant par refroidissement ou par échauffement des bornes de contact correspondantes, lesquelles utilisent le changement de forme occasionné par les variations de température, ou qui travaillent dans les domaines de déformation des parties enfichables telles que domaines super-élastiques, pour T°>Ms, ou dans le domaine dit caoutchoutique pour T°< à Mf (Mf étant la température à laquelle la totalité de l'alliage est en phase martensitique), soit dans le domaine intermédiaire par composition des effets précédents, c'est-à-dire en fait pour Ms<T°<Mf.

Une variante de mise en oeuvre du processus dit d'éducation sera donnée à titre d'exemple non limitatif en liaison avec la figure 2b.

Selon cette variante, le processus consiste à imposer, en l'absence de déformation à l'objet constitué par la borne de contact 10, conformée dans son état initial, une contrainte thermique consistant en une variation de température capable d'amener la borne de contact 10, ou au moins la partie enfichable 100 de celle-ci, en état de phase cristallographique martensitique. Puis, la partie enfichable 100 étant dans l'état précité, une contrainte mécanique, telle que la partie enfichable 100 soit déformée, est appliquée de manière à amener la partie enfichable 100 dans une position ou état de forme voisine du deuxième état de mémoire de forme II. L'abaissement de température et l'application de la contrainte mécanique peuvent être effectués à l'aide des moyens déjà cités, l'application de la contrainte mécanique pouvant être effectuée dans le bain d'azote lorsque la source de froid est constituée par un tel bain. Puis un état de forme dit intermédiaire, voisin de l'état de forme initial de la partie enfichable 100, est ensuite défini et imposé à celle-ci. L'imposition de l'état de forme intermédiaire à la partie enfichable 100 est effectuée par imposition des limites de changement ultérieur de forme de celle-ci aux limites correspondantes de l'état de forme intermédiaire. Par état de forme intermédiaire voisin de l'état de forme initial, on entend un état de forme dans lequel le retour à l'état initial a été obtenu ou à une forme voisine de celui-ci. La définition et l'imposition des limites de changement de forme de la partie enfichable 100 peuvent être effectuées au moyen d'une matrice enserrant la partie enfichable 100, la matrice ayant des dimensions intérieures correspondantes aux dimensions de l'état de forme intermédiaire. La partie enfichable 100 en état martensitique à laquelle les limites de changement de forme ont été imposées est ensuite soumise à un réchauffement progressif à température ambiante pour ramener celle-ci en état de phase cristallographique de type austénitique. Du fait du réchauffement et du maintien de la partie enfichable 100 à l'état de forme intermédiaire, des contraintes internes permettant la définition de l'état de forme intermédiaire comme premier état de mémoire de forme I sont alors induites dans la partie enfichable 100.

Afin d'améliorer la tenue au vieillissement des bornes de contact 10 précédemment décrites, celles-ci peuvent en outre être munies d'un revêtement protecteur conducteur pouvant consister en un dépôt d'or, d'alliage de palladium, d'argent ou d'étain plomb réalisé selon les techniques habituelles. Dans le cas du dernier revêtement précité, celui-ci peut en effet être utilisé en élargissement de son champ d'utilisation habituelle, puis qu'il n'existe pratiquement plus de problème de frottement ni d'usure, notamment lors de l'utilisation de deux étants de mémoire de forme mémorisés.

Selon un mode de réalisation de l'invention, la partie enfichable de la borne de contact est sensiblement de forme cylindrique de façon à constituer un manchon ouvert sur une de ses lignes génératrices sensiblement.

Ainsi, chaque borne de contact comporte essentiellement une zone de raccordement 90 susceptible de recevoir un câble électrique à connecter. Une partie enfichable 100 est mécaniquement solidaire de la zone de raccordement et de la partie active de contact 101 mâle ou femelle.

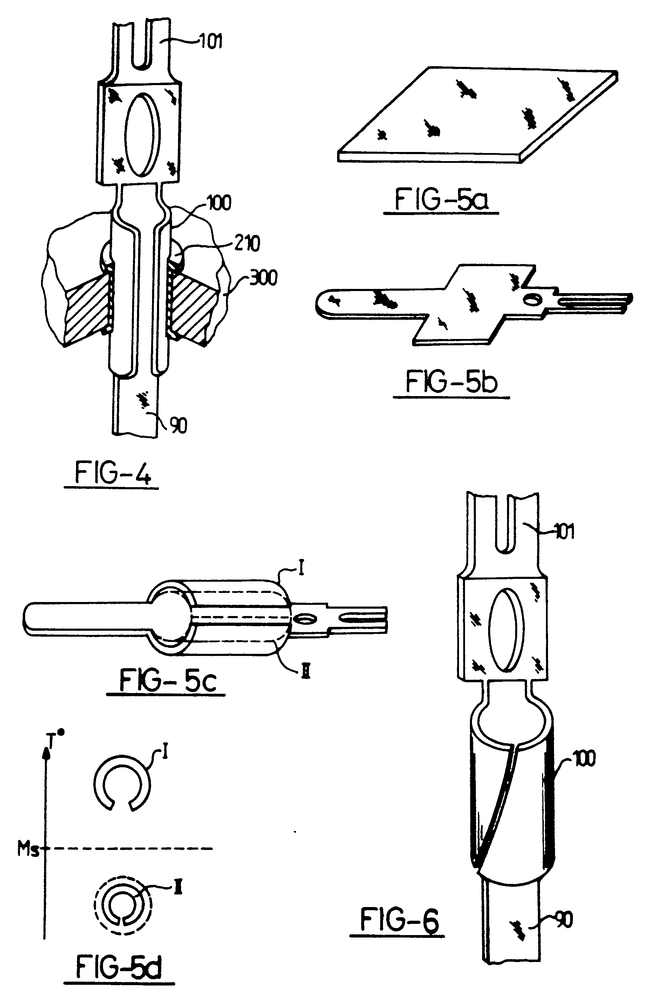

Conformément à la variante de réalisation de la présente invention, ainsi que représenté notamment en figure 4, la partie enfichable 100 est sensiblement de forme cylindrique de façon à constituer un manchon ouvert selon une de ses lignes génératrices. Sur la figure 4, on a représenté la borne de contact objet de l'invention, enfichée dans un orifice correspondant muni d'une métallisation 210 d'un circuit imprimé multicouches noté 300.

La zone de raccordement 90 peut être constituée par un élément parallélépipédique ou tige de section sensiblement rectangulaire.

Bien entendu, la borne de contact selon l'invention peut être réalisée soit en totalité, soit par exemple au niveau de la partie enfichable 100, en un matériau à mémoire de forme appartenant par exemple, ainsi que déjà cité dans la présente description dans le groupe des composés nickel-titane, nickel-aluminium, nickel-titane-fer, cuivre-zinc-aluminium, cuivre-aluminium-nickel sous forme de composés intermétalliques ou sous forme alliée.

Bien entendu, la composition de matériau citée à titre d'exemple précédemment dans la description, composition selon laquelle le matériau comporte 4% d'aluminium, 28% de zinc et le reste du pourcentage en cuivre, de manière à obtenir une température de transition voisine de −80°C de ce matériau, peut être avantageusement utilisée. La seule variation en deçà et/ou au delà de la température de la partie enfichable 100 ou éventuellement de l'ensemble de la borne de contact permet le passage de l'un à l'autre des états de forme mémorisés ou non.

On comprendra en effet, que le type de borne de contact représenté et décrit au moyen de la figure 4 permet d'obtenir un système de connexion dans lequel l'introduction et/ou le retrait des bornes de contact de leur orifice correspondant peut être effectué à force d'insertion ou de retrait quasi nulle et pratiquement en l'absence d'usure. Ce mode de réalisation apparaît particulièrement bien adapté pour la connexion des circuits imprimés multicouches comportant une métallisation 210 au niveau de l'orifice ou non, en raison de l'adaptation de la partie enfichable 100 à l'orifice en l'absence de déformation localisée de celui-ci.

Un mode opératoire permettant d'obtenir une borne de contact comportant deux états de forme mémorisés, conformément à l'invention, sera maintenant décrit en liaison avec les figures 5a, 5b, 5c et 5d.

Ainsi que représenté en figures 5a et 5b, la borne de contact peut être obtenue de manière avantageuse, à partir d'une feuille métallique, forme sous laquelle le matériau à mémoire de forme considéré est disponible dans le commerce, puis par découpage selon le schéma de la figure 5b. Cette découpe peut être réalisée par tout moyen habituel. On remarquera que la découpe représentée consiste pour l'essentiel, en une bande longitudinale à laquelle sont ajoutés deux lobes latéraux sensiblement symétriques, le tout bien entendu formant une seule et même pièce.

Puis, la partie enfichable 100 au départ constituée par les deux lobes latéraux symétriques est alors amenée par roulage dans sa position finale notée I sur la figure 5c, laquelle constitue le premier état de mémoire de forme ainsi que représenté sur les figures 4 et 5c. La partie enfichable 100 est ainsi constituée en un manchon ouvert selon l'une de ses lignes génératrices.

La borne de contact telle que représentée en figure 5c, est alors soumise à un traitement thermique capable d'amener celle-ci en état de phase cristallographique de type austénitique puis à un refroidissement de type trempage, de façon à éviter l'apparition de phase cristallographique parasite, ainsi que déjà décrit précédemment dans la description. La borne de contact est alors soumise au niveau de sa partie enfichable 100, à un processus dit d'éducation, lequel sera décrit en liaison avec la figure 5d.

Le processus d'éducation consiste à imposer répétitivement à la partie enfichable 100, une contrainte mécanique, telle que cette dernière soit dans cette zone déformée de manière à amener la partie enfichable 100 dans une position de forme voisine du deuxième état de forme mémorisé et à soumettre l'ensemble, la contrainte étant maintenue, à un abaissement de température susceptible d'amener la partie enfichable 100 en état de phase martensitique. Sur la figure 5d, on voit que la deuxième position de forme mémorisée correspond en fait à la fermeture du manchon sensiblement, de façon que la section de la partie enfichable 100, dans cette position, soit très inférieure à la section correspondante de la même partie enfichable en positon de forme mémorisée I, laquelle représentée en trait mixte, correspond sensiblement à celle de l'orifice ou de sa métallisation.

Après suppression de la contrainte mécanique, la borne de contact est soumise à un réchauffement progressif à température ambiante; celle-ci reprend alors son état de forme stable ou premier état de mémoire de forme. La répétition du cycle imposé pour l'éducation telle que définie précédemment, permet d'obtenir les états de forme mémorisés réversibles I et II. Le passage de l'un à l'autre état de forme, peut alors être obtenu, après éducation, par simple variation de la température de la partie enfichable 100 ou de la borne de contact ainsi que déjà décrit.

Bien entendu, la borne de contact objet de l'invention peut également être mise en oeuvre en l'absence du processus d'éducation tel que défini précédemment, le passage de l'état de forme mémorisé I, à l'état de forme non mémorisé II, pouvant être obtenu par abaissement de la température de la partie enfichable 100 en deçà de la température de transition, sous l'effet des contraintes mécaniques exercées par l'orifice ou la métallisation de celui-ci sur la partie enfichable 100, le retour à la position de forme initiale noté I, celle-ci étant mémorisée, s'effectuant par le retour à la température ambiante.

Bien entendu, des variantes de réalisation de la partie enfichable 100 peuvent être prévues, sans sortir du cadre de la présente invention.

Ainsi, à titre d'exemple non limitatif, la partie enfichable 100 constituant manchon ouvert, peut comprendre au niveau de l'ouverture selon une ligne génératrice, une ouverture effilée vers au moins une des extrémités de celle-ci, de façon à permettre le libre jeu des lobes constituant les parois latérales du manchon fendu, par seule modification de la température de celui-ci, en deçà et au délà de la température de transition du matériau à mémoire de forme le constituant.

De préférence, dans la partie centrale du manchon, les bords de la fente ou ouverture sont sensiblement parallèles. Selon un mode de réalisation particulièrement avantageux de la borne de contact telle que représentée en figure 6, la partie enfichable 100 est constituée par un manchon ouvert selon une ligne oblique par rapport à une de ses génératrices. Ce mode de réalisation présente l'avantage d'autoriser une plus large tolérance de variation des cotes du manchon ou du trou.

Le manchon ainsi formé peut être également obtenu à partir d'un découpage approprié puis par roulage. Bien entendu les modes de réalisation précités ne sont pas limitatifs. En particulier, les bornes telles que les bornes de contact précédemment décrites dans la présente description peuvent être constituées en totalité ou en partie en un matériau à mémoire de forme. En particulier, la seule partie enfichable peut être constituée en un matériau à mémoire de forme, la zone de contact étant constituée par une partie métallique rapportée par brasure, soudure, sertissage par exemple.

La mise en oeuvre d'un connecteur électrique, conformément à l'invention, peut être réalisée ainsi qu'il a été décrit précédemment dans la description, une au moins des bornes de contact étant constituées par la borne de contact décrite dans la présente demande.

**Revendications**

1. Connecteur électrique thermo-enfichable sur une carte de circuit imprimé (200) munie d'orifices métallisés (210) comprenant une pluralité de bornes de contact (10), mâles ou femelles, enfichables rendues solidaires par au moins un support isolant, caractérisé en ce que lesdites bornes de contact comportent au moins une partie enfichable (100) qui est constituée en un matériau à mémoire de forme, et que ladite partie enfichable de chacune des bornes est conformée, d'une part aux dimensions de sa forme finale d'utilisation après enfichage, correspondant à son état de mémoire de forme stable, de manière à assurer la rétention mécanique et le contact électrique avec ledit orifice, et d'autre part de façon à occuper sous l'influence des contraintes mécaniques exercées par l'orifice correspondant un deuxième état de forme non mémorisé à une température inférieure à la température de transition Ms du matériau pour pouvoir être introduite et/ou retirée de son orifice.

2. Connecteur électrique thermo-enfichable sur une carte de circuit imprimé (200) munie d'orifices métallisés (210) comprenant une pluralité de bornes de contact (10) mâles ou femelles, enfichables rendues solidaires par au moins un support isolant, caractérisé en ce que lesdites bornes de contact comportent au moins une partie enfichable (100) qui est constituée en un matériau à mémoire de forme, et que ladite partie enfichable de chacune des bornes est conformée, d'une part aux dimensions de sa forme finale d'utilisation après enfichage, correspondant sensiblement à un premier état de mémoire de forme stable, de manière à assurer la rétention mécanique et le contact électrique avec ledit orifice, et d'autre part de façon à pouvoir être introduite et/ou retirée de son orifice correspondant dans un deuxième état de mémoire de forme mémorisé stable dudit matériau, les transitions entre le premier état et le deuxième état de mémoire de forme étant obtenues par seul abaissement de la température à une température inférieure à la température de transition (Ms) du matériau à mémoire de forme puis par une élévation successive de la température à une température supérieure à la température (Af) du matériau pour retour à l'état austénitique.

3. Connecteur électrique selon l'une des revendications 1 ou 2, caractérisé en ce que le premier état de mémoire de forme est stable à la température ambiante.

4. Connecteur électrique selon l'une des revendications 1 ou 2, caractérisé en ce que le premier état de mémoire de forme est stable à basse température.

5. Connecteur électrique selon l'une des revendications 1 à 4, caractérisé en ce que chaque borne de contact comporte:

une zone de raccordement (90) susceptible de recevoir un câble électrique à connecter,

une partie enfichable (100) allongée, mécaniquement solidaire de ladite zone de raccordement, ladite partie enfichable ayant au moins une dimension transversale à son axe longitudinal sensiblement variable.

6. Connecteur électrique selon la revendication 5, caractérisé en ce que ladite partie enfichable est sensiblement en forme de lame et comporte un ou plusieurs évidements (103).

7. Connecteur électrique selon l'une des revendications 1 à 6 précédentes, caractérisé en ce que la totalité de la borne est constituée en un matériau à mémoire de forme.

8. Connecteur électrique selon l'une des revendications 1 à 7 précédentes, caractérisé en ce que ledit matériau à mémoire de forme est choisi dans le groupe des composés nickel-titane, nickel-aluminium, nickel-titane-fer, cuivre-zinc-aluminium, cuivre-aluminium-nickel, sous forme de composé intermétallique ou allié.

9. Connecteur électrique selon l'une des revendications précédentes, caractérisé en ce que chacune des bornes de contact comporte un revêtement protecteur conducteur.

10. Borne de contact thermo-enfichable, sur une carte de circuit imprimé (200) munie d'orifices métallisés (210), caractérisée en ce qu'elle est constituée en un matériau à mémoire de forme et qu'elle comporte:

une zone de raccordement (90) susceptible de recevoir un câble électrique à connecter,

une partie enfichable (100) allongée mécaniquement solidaire de ladite zone de raccordement, ladite partie enfichable étant conformée, d'une part aux dimensions de sa forme finale après enfichage correspondant à son état de mémoire de forme stable de manière à assurer la rétention mécanique et le contact électrique avec ledit orifice, et d'autre part de façon à occuper sous l'influence des contraintes mécaniques exercées par l'orifice correspondant, un deuxième état de forme non mémorisé à une température inférieure à la température de transition Ms du matériau pour pouvoir être introduite et/ou retirée de son orifice.

11. Borne de contact thermo-enfichable sur une carte de circuit imprimé munie d'orifices métallisés, caractérisée en ce qu'elle est constituée en un matériau à mémoire de forme et qu'elle comporte:

une zone de raccordement (90) susceptible de recevoir un câble électrique à connecter,

une partie enfichable (100) allongée mécaniquement solidaire de ladite zone de raccordement, ladite partie enfichable étant conformée, d'une part, aux dimensions de sa forme finale d'utilisation après enfichage correspondant sensiblement à un premier état de mémoire de forme stable de manière à assurer la rétention mécanique et le contact électrique avec ledit orifice, et d'autre part de façon à pouvoir être introduite et/ou retirée de son orifice correspondant dans un deuxième état de mémoire de forme mémorisé stable dudit matériau, les transitions entre le premier état et le deuxième état de mémoire de forme étant obtenues par seul abaissement de la température à une température inférieure à la température de transition (Ms) du matériau à mémoire de forme puis par une élévation successive de la température à une température supérieure à la température (Af) du matériau pour retour à l'état austénitique.

12. Borne de contact électrique selon l'une des revendications 10 ou 11 précédentes, caractérisée en ce qu'elle est constituée en totalité ou en partie en un matériau à mémoire de forme.

13. Borne de contact selon la revendication 12, caractérisée en ce que seule la partie enfichable est constituée en un matériau à mémoire de forme, la zone de contact étant constituée en une partie métallique rapportée.

14. Borne de contact électrique selon l'une des revendications 12 ou 13, caractérisée en ce que ladite partie enfichable (100) est sensiblement de forme cylindrique de façon à constituer un manchon ouvert.

15. Borne de contact selon la revendication 14, caractérisée en ce que le manchon est ouvert selon une de ses lignes génératrices.

16. Borne de contact électrique selon l'une des revendications 12 à 15, caractérisée en ce que la zone de raccordement (90) est constituée par un élement parallélépipédique de section sensiblement rectangulaire.

17. Borne de contact électrique selon l'une des revendications précédentes, caractérisée en ce que ladite borne est constituée par une feuille de matériau à mémoire de forme conformée par découpage puis roulage.

18. Borne de contact électrique selon l'une des revendications 14 à 17, caractérisée en ce que la partie enfichable (100) constituant manchon ouvert selon une de ses lignes génératrices comprend au niveau de celle-ci une ouverture effilée vers au moins une de ses extrémités de façon à permettre le libre jeu des lobes constituant les parois latérales du manchon fendu par modification de la température de celui-ci, en deçà et au delà de la température de transition du matériau le constituant.

19. Borne de contact électrique selon l'une des revendications 15 à 18 caractérisée en ce que dans la partie centrale du manchon, les bords de la fente ou ouverture sont sensiblement parallèles.

20. Borne de contact selon l'une des revendications 12 ou 13, caractérisée en ce que la partie enfichable (100) est constituée par un manchon ouvert selon une ligne oblique par rapport à une de ses génératrices.

21. Connecteur électrique selon l'une des revendications 1 à 4 précédentes, caractérisé en ce qu'il comprend au moins une borne de contact selon l'une des revendications 12 à 20.

**Patentansprüche**

1. Elektrischer Verbinder, der auf einer gedruckten Leiterplatte (200) thermisch einsteckbar ist, die mit Öffnungen mit Metallüberzug (210) versehen ist, mit einer Mehrzahl stiftartiger oder buchsenartiger einsteckbarer Anschlußklemmen (10), die mittels zumindest eines isolierenden Trägers verbunden sind, dadurch gekennzeichnet, daß die genannten Anschlußklemmen zumindest einen einsteckbaren Teil (100) aufweisen, der aus einem Werkstoff mit Formgedächtnis gebildet ist, und daß der genannte einsteckbare Teil jeder der Klemmen einerseits den Abmessungen seiner endgültigen Form bei der Verwendung nach dem Einstecken angepaßt ist, die seinem formstabilen Gedächtniszustand entspricht, um auf diese Weise mechanisches Festhalten und den elektrischen Kontakt mit der genannten Öffnung sicherzustellen, und andererseits in der Weise angepaßt ist, daß er unter dem Einfluß mechanischer, von der entsprechenden Öffnung ausgeübter Belastungen einen zweiten, nicht gespeicherten Formzustand bei einer Temperatur einnimmt, die niedriger ist als die Übergangstemperatur Ms des Werkstoffs, um in seine Öffnung eingesteckt und/oder aus dieser herausgezogen werden zu können.

2. Elektrischer Verbinder, der auf einer gedruckten Leiterplatte (200) thermisch einsteckbar ist, die mit Öffnungen mit Metallüberzug (210) versehen ist, mit einer Mehrzahl stiftartiger oder buchsenartiger, einsteckbarer Anschlußklemmen (10), die durch zumindest einen isolierenden Träger verbunden sind, dadurch gekennzeichnet, daß die genannten Anschlußklemmen zumindest einen einsteckbaren Teil (100) aufweisen, der aus einem Werkstoff mit Formgedächtnis gebildet ist, und daß der genannte einsteckbare Teil jeder der Klemmen einerseits an die Abmessungen seiner endgültigen Form bei der Verwendung nach dem Einstecken angepaßt ist, die im wesentlichen einem formstabilen ersten Gedächtniszustand entspricht, um auf diese Weise das mechanische Festhalten und den elektrischen Kontakt mit der genannten Öffnung sicherzustellen, und andererseits so angepaßt ist, um in einem zweiten, gespeicherten, formstabilen Gedächtniszustand des genannten Materials eingesteckt und/oder aus seiner betreffenden Öffnung herausgezogen werden zu können, wobei die Übergänge zwischen dem ersten Gedächtniszustand und dem zweiten Gedächtniszustand der Form durch alleiniges Absenken der Temperatur auf eine Temperatur, die unterhalb der Übergangstemperatur (Ms) des Werkstoffs mit Formgedächtnis liegt, und eine nachfolgende Erhöhung der Temperatur auf eine Temperatur erreicht werden, die oberhalb der Temperatur (Af) liegt, bei der der Werkstoff in den austenitischen Zustand zurückkehrt.

3. Elektrischer Verbinder nach einem der Ansprüche 1 oder 2, dadurch gekennzeichnet, daß der erste Zustand des Formgedächtnisses bei der Umgebungstemperatur stabil ist.

4. Elektrischer Verbinder nach einem der Ansprüche 1 oder 2, dadurch gekennzeichnet, daß der erste Zustand des Formgedächtnisses bei niedriger Temperatur stabil ist.

5. Elektrischer Verbinder nach einem der Ansprüche 1 bis 4, dadurch gekennzeichnet, daß jede Anschlußklemme aufweist:

eine Verbindungszone (90) für die Aufnahme eines anzuschließenden elektrischen Kabels,

einen langgestreckten einsteckbaren Teil (100), der mit der genannten Verbindungszone mechanisch verbunden ist, wobei der genannte einsteckbare Teil zumindest eine quer zu seiner Längsachse gemessene Abmessung besitzt, die beträchtlich variabel ist.

6. Elektrischer Verbinder nach Anspruch 5, dadurch gekennzeichnet, daß der genannte einsteckbare Teil im wesentlichen die Form einer Zunge besitzt und eine oder mehrere Aussparungen (103) aufweist.

7. Elektrischer Verbinder nach einem der vorausgehenden Ansprüche 1 bis 6, dadurch gekennzeichnet, daß die gesamte Klemme aus einem Werkstoff mit Formgedächtnis gebildet ist.

8. Elektrischer Verbinder nach einem der vorausgehenden Ansprüche 1 bis 7, dadurch gekennzeichnet, daß der genannte Werkstoff mit Formgedächtnis aus der Gruppe der Verbindungen von Nickel-Titan, Nickel-Aluminium, Nickel-Titan-Eisen, Kupfer-Zink-Aluminium, Kupfer-Aluminium-Nickel, in Form einer intermetallischen Verbindung oder einer Legierung, ausgewählt ist.

9. Elektrischer Verbinder nach einem der vorausgehenden Ansprüche, dadurch gekennzeichnet, daß jede der Anschlußklemmen einen leitenden Schutzüberzug aufweist.

10. Thermisch einsteckbare Anschlußklemme auf einer gedruckten Leiterplatte (200), die mit Öffnungen mit Metallüberzug (210) versehen ist, dadurch gekennzeichnet, daß sie aus einem Werkstoff mit Formgedächtnis gebildet ist und daß sie aufweist:

eine Verbindungszone (90) für die Aufnahme eines anzuschließenden elektrischen Kabels,

einen langgestreckten einsteckbaren Teil (100), der mit der genannten Verbindungszone mechanisch verbunden ist, wobei der genannte einsteckbare Teil einerseits an die Abmessungen seiner endgültigen Form nach dem Einstecken angepaßt ist, die seinem formstabilen Gedächtniszustand entspricht, um das mechanische Festhalten und den elektrischen Kontakt mit der genannten Öffnung sicherzustellen, und andererseits so angepaßt ist, daß er unter Einfluß von mechanischen Belastungen, die durch die betreffende Öffnung ausgeübt werden, um eingesteckt werden und/oder aus seiner Öffnung herausgezogen werden zu können, einen nicht gespeicherten zweiten Formzustand bei einer Temperatur einnimmt, die niedriger ist als die Übergangstemperatur Ms des Werkstoffs.

11. Thermisch einsteckbare Anschlußklemme auf einer gedruckten Leiterplatte, die mit Öffnungen mit einer Metallisierung versehen ist, dadurch gekennzeichnet, daß sie aus einem Werkstoff mit Formgedächtnis gebildet ist und sie aufweist:

eine Verbindungszone (90) für die Aufnahme eines anzuschließenden elektrischen Kabels,

einen langgestreckten einsteckbaren Teil (100), der mit der genannten Verbindungszone mechanisch verbunden ist, wobei der genannte einsteckbare Teil einerseits an die Abmessungen seiner endgültigen Form bei der Verwendung nach dem Einstecken angepaßt ist, die im wesentlichen einem formstabilen ersten Gedächtniszustand entspricht, um das mechanische Festhalten und den elektrischen Kontakt mit der genannten Öffnung sicherzustellen, und andererseits so angepaßt ist, um in einem zweiten gespeicherten formstabilen Gedächtniszustand des genannten Werkstoffs eingesteckt und/oder aus seiner betreffenden Öffnung herausgezogen werden zu können, wobei die Übergänge zwischen dem ersten und dem zweiten Gedächtniszustand der Form allein durch Absenken der Temperatur auf eine Temperatur, die niedriger ist als die Übergangstemperatur (Ms) des Werkstoffes mit Formgedächtnis, und durch eine nachfolgende Anhebung der Temperatur auf eine Temperatur erreicht werden, die oberhalb der Temperatur (Af) liegt, bei der der Werkstoff in den austenitischen Zustand zurückkehrt.

12. Elektrische Anschlußklemme nach einem der vorausgehenden Ansprüche 10 oder 11, dadurch gekennzeichnet, daß sie ganz oder teilweise aus einem Werkstoff mit Formgedächtnis gebildet ist.

13. Anschlußklemme nach Anspruch 12, dadurch gekennzeichnet, daß lediglich der einsteckbare Teil aus einem Werkstoff mit Formgedächtnis gebildet ist und daß die Kontaktzone aus einem angesetzten metallischen Teil gebildet ist.

14. Elektrische Anschlußklemme nach einem der Ansprüche 12 oder 13, dadurch gekennzeichnet, daß der genannte einsteckbare Teil (100) im wesentlichen eine solche zylindrische Form besitzt, daß er eine offene Hülse bildet.

15. Anschlußklemme nach Anspruch 14, dadurch gekennzeichnet, daß die Hülse längs einer ihrer Mantellinien geöffnet ist.

16. Elektrische Anschlußklemme nach einem der Ansprüche 12 bis 15, dadurch gekennzeichnet, daß die Verbindungszone (90) durch ein Element in Form eines Parallelepipeds von im wesentlichen rechteckförmigem Querschnitt gebildet ist.

17. Elektrische Anschlußklemme nach einem der vorausgehenden Ansprüche, dadurch gekennzeichnet, daß die genannte Klemme aus einem Streifen eines Werkstoffs mit Formgedächtnis durch Stanzen und anschließendes Rollformen gebildet ist.

18. Elektrische Anschlußklemme nach einem der Ansprüche 14 bis 17, dadurch gekennzeichnet, daß der einsteckbare Teil (100), der die längs eine ihrer Mantellinien offene Hülse bildet, auf Höhe derselben eine Öffnung besitzt, die gegen zumindest eines ihrer Enden hin spitz zuläuft, um freies Spiel für die Lappen, die die Seitenwände der geschlitzten Hülse bilden, zu ermöglichen, wenn deren Temperatur zwischen Werten unterhalb und oberhalb der Übergangstemperatur des sie bildenden Werkstoffs geändert wird.

19. Elektrische Anschlußklemme nach einem der Ansprüche 15 bis 18, dadurch gekennzeichnet, daß in dem zentralen Teil der Hülse die Ränder des Durchbruchs oder der Öffnung im wesentlichen parallel sind.

20. Anschlußklemme nach einem der Ansprüche 12 oder 13, dadurch gekennzeichnet, daß der einsteckbare Teil (100) durch eine Hülse gebildet ist, die längs einer Linie geöffnet ist, die schräg zu einer ihrer Mantellinien verläuft.

21. Elektrischer Verbinder nach einem der vorausgehenden Ansprüche 1 bis 4, dadurch gekennzeichnet, daß er zumindest eine Anschlußklemme nach einem der Ansprüche 12 bis 20 aufweist.

## Claims

1. Electric connector thermo-insertable onto a printed circuit card provided with metallised apertures comprising a plurality of insertable male or female contact terminals combined together by at least one insulating support, characterized in that:

said contact terminals have at least one insertable part, of shape-memory material, said insertable part of each of said terminals being shaped, on the one hand, to final shape dimensions of use after insertion, corresponding to its stable shape-memory state, in a manner to ensure mechanical retention and electric contact with said aperture, and, on the other hand, in a manner to occupy, under the influence of stresses exerted by said corresponding aperture a second non-memorised shape state at temperature lower than the transition temperature Ms of said material in a manner to be able to be introduced and/or withdrawn from said aperture.

2. Electric connector thermo-insertable onto a printed circuit card provided with metallised apertures comprising a plurality of insertable male or female contact terminals combined together by at least one insulating support, characterized in that:

said contact terminals have at least one insertable part, of shape-memory material, said insertable part of each of said terminals being shaped, on the one hand, to the final use dimensions after insertion, corresponding substantially to a first stable shape-memory state, in a manner to ensure mechanical retention and electric contact with said aperture, and, on the other hand, in a manner to be able to be introduced and/or withdrawn from its corresponding aperture in a second stable shape-memory state of said material, transitions between the first and second shape-memory states being obtained by the mere lowering of the temperature to a temperature lower than the transition temperature (Ms) of the shape-memory material, then a successive elevation of the temperature to a temperature greater than the temperature (Af) for the return to the austenitic state.

3. Electric connector according to claim 1, wherein said first shape-memory state is stable at ambient temperature.

4. Electric connector according to claim 1, wherein said first shape-memory state is stable at low temperature.

5. Electric connector according to claim 1, wherein each said contact terminal comprises:

a connection zone able to receive a connecting electric cable,

an elongate insertable part mechanically fixed to said connection zone, said insertable part having at least one substantially variable dimension transverse to its longitudinal axis.

6. Electric connector according to claim 5, wherein said insertable part is substantially in the form of a blade and has one or more cut-outs.

7. Electric connector according to claim 1, wherein said terminal is entirely of shape-memory material.

8. Electric connector according to claim 1, wherein said shape-memory material is chosen amongst the group of compositions nickel-titanium, nickel-aluminium, nickel-titanium-iron, copper-zinc-aluminium, copper-aluminium-nickel, in alloy or inter-metallic composition form.

9. Electric connector according to claim 1, wherein each said contact terminal has a protective conductive covering.

10. Contact terminal thermo-insertable, onto a printed circuit card provided with metallised apertures, wherein:

said terminal is of shape-memory material and said terminal comprises:

a connection zone able to receive a connecting electric cable,

an elongate insertable part mechanically fixed to said connection zone, said insertable part being shaped, on the one hand to the final shape dimensions after insertion, corresponding to its stable shape-memory state, in a manner to ensure mechanical retention and electric contact with said aperture, and, on the other hand, in a manner to occupy under the influence of stresses exerted by said corresponding aperture, a second non-memorised shape state at temperature lower than the transition temperature Ms of said material in a manner to be able to be introduced and/or withdrawn from said aperture.

11. Contact terminal thermo-insertable onto a printed circuit card provided with metallised apertures, wherein:

said terminal is of shape-memory material and said terminal comprises:

a connection zone able to receive a connecting electric cable,

an elongate insertable part, mechanically fixed to said connection zone, said insertable part being shaped, on the one hand, to the dimensions of its final use shape after insertion, corresponding substantially to a first stable shape-memory state, in a manner to ensure mechanical retention and electric contact with said aperture, and, on the other hand, in a manner to be able to be introduced and/or withdrawn from the corresponding aperture in a second stable shape-memory state of the said material, transitions between the first and second shape-memory states being obtained by the mere lowering of the temperature to a temperature lower than the transition temperature (Ms) of the shape-memory material, then a successive elevation of the temperature to a temperature greater than the temperature (Af) for the return of the austenitic state.

12. Contact terminal according to claim 10 or 11, wherein said terminal is entirely or in part of shape-memory material.

13. Contact terminal according to claim 12, wherein said insertable part alone is of shape-memory material, said contact zone being of an added metallic material.

14. Contact terminal according to claim 12 or 13, wherein said insertable part is substantially of cylindrical shape in a manner to constitute an open sleeve.

15. Contact terminal according to claim 14, wherein said sleeve is open along one of its generatrix lines.

16. Contact terminal according to one of claims 12 to 15, wherein said connecton zone is constituted by a substantially rectangular element of parallelepipedic cross-section.

17. Contact terminal according to one of claims 10 to 16, wherein said terminal is constituted by a sheet of shape-memory material formed by stamping and then rolling.

18. Contact terminal according to one of claims 14 to 17, wherein said insertable part constituting a sleeve open along one of its generatrix lines comprises at said line an opening tapering towards at least one of its ends in a manner to permit free movement of ears constituting the lateral walls of said split sleeve by modification of the temperature of it, below or above the transmission temperature of its constituent material.

19. Contact terminal according to one of claims 15 to 18, wherein in a central part of said sleeve, the edges of its slit or opening are substantially parallel.

20. Contact terminal according to claim 12 or 18, wherein said insertable part is constituted by a sleeve open along a line angled with respect to one of its generatrices.

21. Electric connector according to one of claims 1 to 4, said connector comprising at least one contact terminal according to one of claims 12 to 20.

FIG-1a

FIG-1b

FIG-2a

FIG-2b

FIG-3

FIG-4

FIG-5a

FIG-5b

FIG-5c

FIG-5d

FIG-6